Europäisches Patentamt

(19) European Patent Office

Office européen des brevets

(11) Numéro de publication: **0 056 668**
**A1**

(12) # DEMANDE DE BREVET EUROPEEN

(21) Numéro de dépôt: **82200024.6**

(22) Date de dépôt: **11.01.82**

(51) Int. Cl.³: **H 05 K 3/20**

(30) Priorité: **16.01.81 FR 8101104**

(43) Date de publication de la demande:
**28.07.82 Bulletin 82/30**

(84) Etats contractants désignés:
**AT BE CH DE FR GB IT LI NL SE**

(71) Demandeur: **Delair, Michel**
**76 Labastide Falgarde**
**F-31120 Lacroix Falgarde(FR)**

(72) Inventeur: **Delair, Michel**
**76 Labastide Falgarde**
**F-31120 Lacroix Falgarde(FR)**

(74) Mandataire: **Barre, Philippe**
**Cabinet Barre, Gatti, Laforgue 95, rue des Amidonniers**
**F-31069 Toulouse Cedex(FR)**

(54) **Procédé de fabrication de couches de circuits imprimés et outillage de mise-en-oeuvre.**

(57) L'invention concerne un procédé de fabrication de couches de circuits imprimés, comprenant essentiellement quatre phases :

a) réalisation d'une plaque-outil $P_1$ réutilisable, constituée en surface d'un matériau électriquement conducteur 1 partiellement recouvert d'un revêtement isolant 5' adhérant sur ce matériau et reproduisant le schéma inverse des dépôts conducteurs de la couche à réaliser.

b) garniture électrolytique des parties métalliques de la plaque-outil au moyen d'un matériau conducteur.

c) transfert dudit matériau conducteur sur un support isolant par pressage et chauffage.

d) séparation de la plaque-outil et du support isolant afin d'obtenir la couche du circuit imprimé dotée de dépôts conducteurs reproduisant le schéma électrique désiré et de reconstituer la plaque-outil $P_1$ telle que réalisée en (a) en vue d'un nouveau cycle (b), (c), (d).

Fig.2

1

# PROCEDE DE FABRICATION DE COUCHES DE CIRCUITS
# IMPRIMES ET OUTILLAGE DE MISE-EN-OEUVRE

L'invention concerne un procédé de fabrication de couches de circuits imprimés, lesdites couches étant notamment destinées à permettre la réalisation par collage de circuits imprimés multi-couches ; elle s'étend à des outillages pour la mise en oeuvre de ce procédé et aux produits ainsi fabriqués.

On sait que les circuits imprimés multi-couches utilisés dans l'industrie électronique, sont destinés à recevoir des composants actifs ou passifs (transistors, micro-processeurs, circuits intégrés, résistances, condensateurs...) et à assurer les liaisons électriques entre ces derniers. Ces circuits imprimés multicouches sont constitués par plusieurs couches superposées et collées les unes sur les autres, chaque couche étant formée d'un support isolant sur les faces duquel sont disposées des dépôts conducteurs (encore désignés par pistes conductrices ou impressions conductrices) présentant un schéma correspondant aux liaisons électriques à établir ; les liaisons électriques entre les diverses nappes conductrices sont généralement assurées par des trous métallisés dont certains servent à recevoir les queues des composants.

Il existe actuellement essentiellement deux méthodes pour réaliser, préalablement à leur collage, chacune des couches d'un circuit imprimé.

Une première méthode, dite soustractive, qui est la plus utilisée par l'industrie, consiste à fixer sur un support isolant un laminé continu de cuivre puis à recouvrir d'une couche de protection les zones de cuivre qui sont appelées à constituer les pistes conductrices de la couche ; le procédé se poursuit par une opération de gravure des zones de cuivre non protégées, laissant intacte les seules zones protégées, puis par une opération de dépelliculage de la couche de protection.

Une seconde méthode, dite additive, consiste à réaliser une enduction inverse d'un support isolant "présensibilisé" au moyen d'une couche protectrice, qui est disposée sur les zones appelées à constituer les zones isolantes de la couche ; le procédé se poursuit par une opération chimique consistant à déposer du cuivre sur les zones non protégées, puis par une opération de dépelliculage de la couche protectrice.

Les méthodes soustractives et additives ci-dessus évoquées présentent plusieurs inconvénients. En premier lieu, elles conduisent, pour la fabrication de chacune des couches des circuits imprimés, à consommer des matières élaborées, très onéreuses, telles que matériaux de base, films photopolymérisables, solvants, produits de gravure etc... En outre, elles sont mises en oeuvre sur des équipements nombreux, représentant des investissements élevés (machines de préparation de surface, d'enduction, de dépelliculage, d'insolation, de développement, de gravure,...). Enfin, ces méthodes constituent une suite d'opérations qui, pour la plupart, sont délicates et font appel à une main-d'oeuvre spécialisée ; certaines des opérations peuvent induire des dérives (défaut de positionnement de chaque enduction, défaut d'adhérence des couches de protection...) qui sont suceptibles de se cumuler et de provoquer un taux de rebut relativement élevé.

Par ailleurs, on a proposé des variantes de la méthode additive, consistant à utiliser un support auxiliaire constitué par une simple plaque métallique : pour fabriquer chaque couche, on réalise sur cette plaque métallique un dépôt de matériau conducteur selon le schéma des pistes de la couche à réaliser, ce dépôt étant obtenu par une succession d'opérations appropriées, analogues à celles de la méthode additive (enduction d'un film photo-polymérisable, polymérisation du film à travers un cliché, développement ou dépôt d'encre sérigraphique, dépôt électrolytique de matériau conducteur, dépelliculage,...). La plaque auxiliaire pourvue des pistes conductrices, sert ensuite à transférer, par collage à chaud et sous pression, lesdites pistes sur le support isolant définitif. La plaque se retrouve alors nue et, après nettoyage, le cycle complet de fabrication est exécuté à nouveau, d'abord pour mettre en place sur la plaque nue les pistes conductrices par la succession des opérations ci-dessus évoquée, ensuite pour transférer celles-ci sur le support isolant.

Une telle variante est en particulier décrite dans le brevet GB n° 825.495. Toutefois, elle ne supprime pas les inconvénients des méthodes classiques, qui ont été évoquées précédemment ; en effet, la succession complète des opérations de fabrication doit être entièrement exécutée pour la fabrication de chaque couche puisque à la fin d'un cycle de fabrication, la plaque auxiliaire se retrouve nue et qu'elle doit subir à nouveau tous les traitements, avant de réaliser le transfert des pistes conductrices vers le support définitif de la couche ; en conséquence, les inconvénients liés à la consommation de matières onéreuses, à la qualité et à l'importance de la main-d'oeuvre nécessaire et aux coûts des équipements demeurent présents. De plus, l'opération de transfert des pistes conductrices depuis le support auxiliaire vers le support isolant définitif est une opération extrêmement délicate en raison des risques de déchirements des pistes ou encore des collages intempestifs qui se produisent la plupart du temps entre ces deux supports en dehors des zones occupées par les pistes. Cette opération augmente considérablement le taux de rebut constaté.

La présente invention se propose de reduire, d'une façon significative, les inconvénients des méthodes classiques tant au niveau de la consommation des matières onéreuses, qu'aux niveaux de la main-d'oeuvre et des équipements nécessaires.

Un objectif de l'invention est également d'améliorer la qualité des circuits réalisés et de réduire le taux des rebuts.

Un autre objectif est de réduire les facteurs de pollution, inhérents à la fabrication industrielle de tels circuits, en particulier en limitant considérablement les volumes d'eaux de rinçage ou de refroidissement rejetés.

Un autre objectif est d'autoriser une fabrication industrielle des couches à haute cadence et dans des conditions aisées.

Le procédé de l'invention vise la fabrication de couches de circuits imprimés, couches à partir desquelles seront généralement réalisés , par empilage et collage, des circuits imprimés multi-couches ; chaque couche est cons-

tituée, de façon classique, par au moins un support électriquement isolant doté sur au moins une face, de dépôts en un matériau électriquement conducteur adhérant sur ledit support, lesdits dépôts étant disposés selon un schéma électrique correspondant aux liaisons électriques à établir dans le circuit imprimé. Le procédé conforme à la présente invention consiste :

- (a) à réaliser au moins un outillage réutilisable, dit plaque-outil, comprenant une plaque de base constituée, au moins en surface, d'un matériau électriquement conducteur et partiellement recouverte d'un revêtement électriquement isolant adhérant sur ladite plaque et reproduisant le schéma inverse des dépôts conducteurs de la couche à réaliser, le matériau conducteur de la plaque de base et le matériau du revêtement isolant étant choisis en fonction des matériaux appelés à constituer le support isolant et les dépôts conducteurs de la couche à réaliser, de sorte que :

. la force d'adhérence du revêtement isolant par rapport à la plaque de base soit supérieure à la force d'adhérence dudit revêtement par rapport au support isolant de la couche à réaliser,

. et que la force d'adhérence de la plaque de base par rapport aux dépôts conducteurs soit inférieure à la force d'adhérence desdits dépôts par rapport au support isolant.

- (b) à déposer sélectivement sur les parties conductrices de la plaque-outil non recouvertes du revêtement isolant, une épaisseur du matériau conducteur appelé à former les dépôts conducteurs de la couche à réaliser,

- (c) à appliquer et presser la plaque-outil ainsi obtenue sur un support isolant afin de transférer et coller l'épaisseur du matériau conducteur sur ledit support,

- (d) à séparer la plaque-outil et le support isolant afin d'obtenir la couche de circuit imprimé et de reconstituer la plaque-outil telle que réalisée en (a).

Par "force d'adhérence" on entend la force nécessaire par unité de surface pour décoller un des matériaux par rapport à l'autre.

De plus, par l'expression : "le revêtement reproduisant un schéma inverse des dépôts conducteurs", on entend que ledit revêtement se trouve situé, à la manière d'un négatif, sur toute la surface de la plaque de base à l'exception des zones correspondant au schéma des dépôts conducteurs, (le matériau conducteur de la plaque de base étant apparent dans ces zones non couvertes par le revêtement.

Dans le cas le plus fréquent où le support isolant de la couche à réaliser est un support de résine polymérisée (notamment résine époxyde), et où les dépôts conducteurs de cette couche sont métalliques (notamment cuivre), la plaque outil peut être réalisée à l'opération (a), en choisissant une plaque de base constituée, au moins en surface, d'un métal du groupe : acier inoxydable, nickel, chrome, aluminium, cuivre et leurs alliages. et en choisissant un revêtement en un matériau du groupe : polytétrafluoroéthylènes, silicones, fluorocarbones. Ces matériaux peuvent, le cas échéant être chargés pour augmenter leur dureté.

Ainsi, le procédé de l'invention conduit à réaliser préalablement une plaque-outil qui est ensuite utilisée pour fabriquer un grand nombre de couches ayant le même schéma électrique. L'opération (a) pour la fabrication de cette plaque-outil est celle qui comporte le plus de difficultés et qui est consommatrice de matières onéreuses ; l'opération (b) est une opération tout-à-fait courante qui peut notamment consister en un simple dépôt électrolytique de métal sur la plaque - outil ; il en est de même des opérations (c) et (d) qui n'entraînent aucune consommation de matière élaborée et exigent simplement la présence de presses qui sont des équipements courants

Compte-tenu de la nature des matériaux en présence, l'opération de démoulage (d) est d'exécution facile sans risque de collages intempestifs ou de déchirements des dépôts ; l'état de surface des matériaux sera maintenu propre (surfaces dégraissées et dépoussiérées), à tous les stades du procédé afin d'éliminer tout problème.

L'opération (a) n'étant produite qu'une fois pour chaque série de couches, on conçoit dans ces conditions les avantages du procédé de l'invention qui limite dans des proportions considérables la consommation de matériaux élaborés tels que films photo-polymérisables ou encres de serigraphie, solvants, produits de gravure etc... Le procédé de l'invention réduit également dans des proportions considérables le nombre des équipements nécessaires comme les machines de préparation des surfaces, les machines d'enduction, les machines à graver etc... Une fois la plaque-outil réalisée, le procédé de l'invention supprime les opérations les plus délicates qui font appel à de la main-d'oeuvre spécialisée, de sorte que le cycle de fabrication d'une couche dans une série donnée (opérations b, c, d,) se trouve extrêmement écourté.

De plus, compte-tenu de la faible fréquence de l'opération (a), le procédé de l'invention permet d'assurer l'exécution de cette opération avec un soin beaucoup plus grand, de façon à éviter de cumuler des défauts et de réduire le taux de rebuts. Il limite également les volumes d'eau de rinçage et volumes d'eau de refroidissement nécessaires par couche fabriquée et, en conséquence, réduit la pollution inhérente à une production donnée.

Par ailleurs, selon un mode de réalisation préféré, notamment dans le cas où le support isolant des couches à réaliser est constitué par une résine polymérisée, l'opération (c) de transfert et de collage des dépôts conducteurs sur le support isolant peut être réalisée simultanément pour plusieurs couches ; selon ce mode de mise en oeuvre, cette opération consiste à réaliser un empilage comprenant des plaques-outils entre lesquelles sont interposées des feuilles de résines non polymérisées, à appliquer une pression sur ledit empilage et à porter celui-ci à une température adaptée pour engendrer la polymérisation de la résine. Bien entendu, dans ce cas, on réalise préalablement le nombre de plaques-outils nécessaires pour constituer l'empilage.

Après avoir fabriqué conformément à l'invention, une série de chacune des couches appelées à constituer un circuit imprimé multi-couche, le procédé d'obtention desdits circuits imprimés consiste, de façon classique, à empiler et coller, sous pression et à chaud, les couches constitutives de chaque circuit multicouche.

L'invention exposée ci-dessus sous sa forme générale sera mieux comprise à la lecture de la description qui suit et à l'examen des dessins annexés qui illustrent plusieurs modes de réalisation du procédé de l'invention ; sur ces dessins qui font partie intégrante de la présente description :

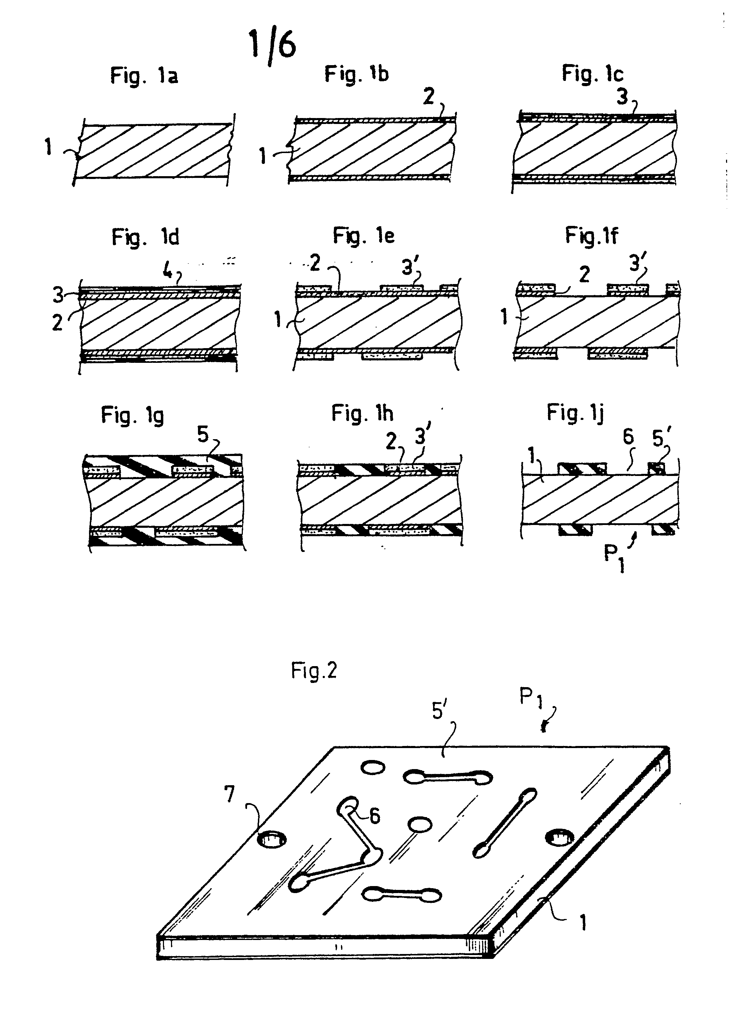

. les figures 1a à 1j illustrent un premier mode de mise en œuvre pour la réalisation d'une plaque-outil conformément à l'opération (a) du procédé de l'invention,

. la figure 2 est une vue schématique en perspective de la plaque-outil obtenue,

. les figures 3a à 3f illustrent un autre mode de mise en oeuvre de cette opération (a) pour l'obtention d'une autre forme de réalisation de plaque-outil,

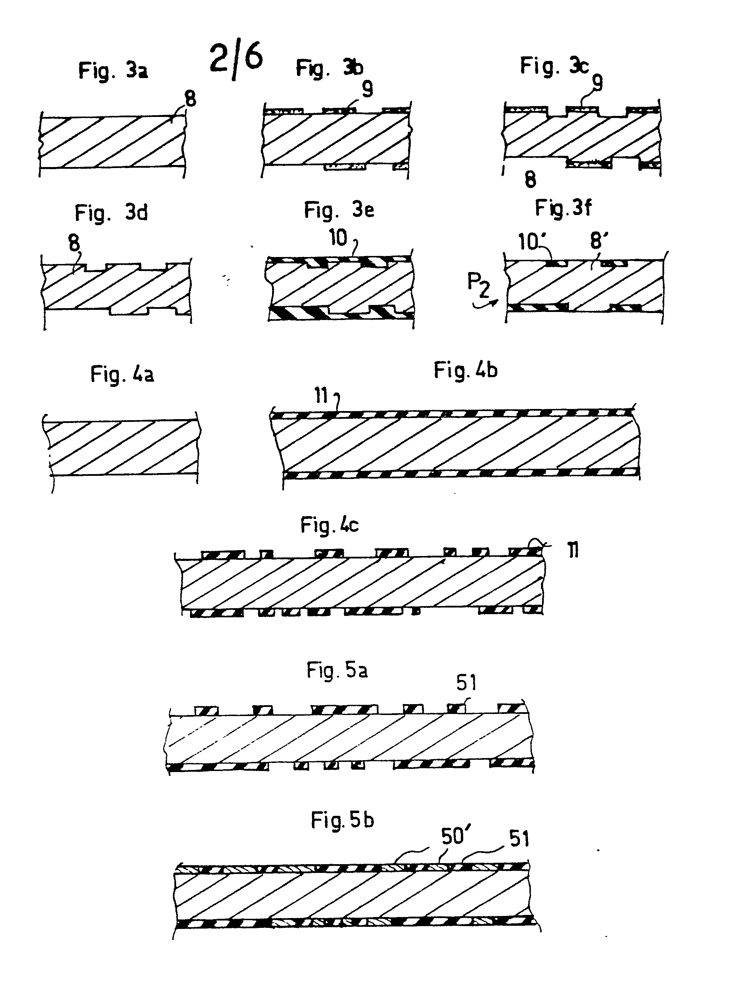

. les figures 4a, 4b et 4c illustrent un autre mode de mise en oeuvre de cette opération (a),

. les figures 5a et 5b illustrent une autre variante de mise en oeuvre de cette opération (a),

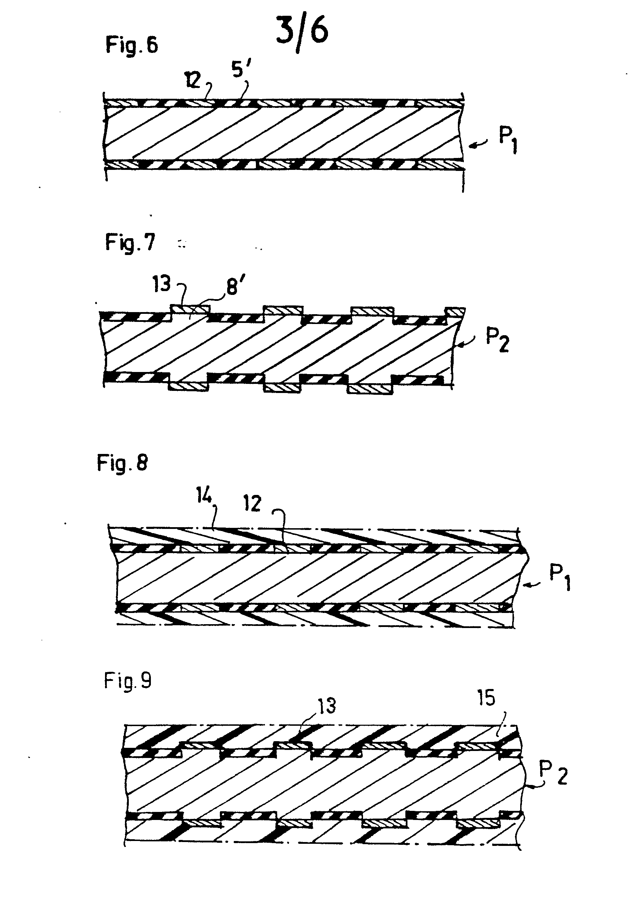

. la figure 6 illustre l'opération (b) du procédé exécutée à partir de la plaque-outil $P_1$ schématisée à la figure 2,

. la figure 7 illustre un autre mode de mise en oeuvre de l'opération (b) à partir de la plaque-outil $P_2$ schématisée à la figure 3f,

. la figure 8 illustre l'opération (c) du procédé exécutée après l'opération (b) schématisée à la figure 6,

. la figure 9 illustre un autre mode de mise en oeuvre de l'opération (c) exécutée après l'opération (b) schématisée à la figure 7,

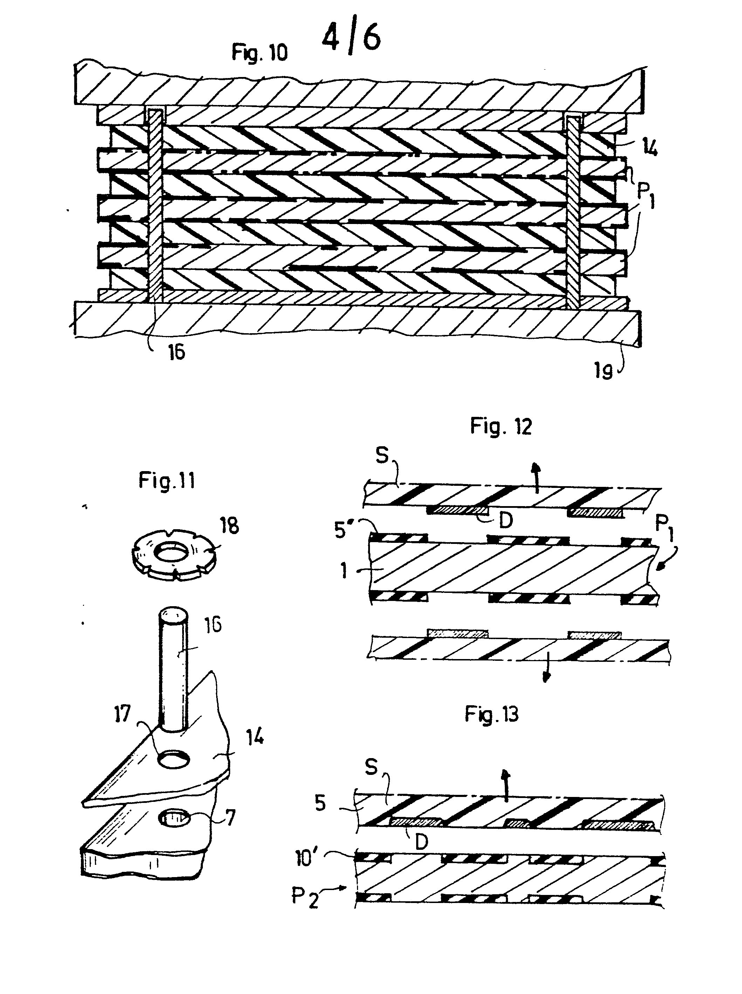

. la figure 10 illustre un mode de mise en oeuvre de l'opération (c) permettant de traiter plusieurs couches simultanément,

. la figure 11 est une vue en perspective à échelle dilatée, d'un détail de la figure 10,

. les figures 12 et 13 illustrent l'opéra-

8

tion (d) du procédé conforme à l'invention, respectivement dans le cas d'une plaque-outil $P_1$ et dans le cas d'une plaque-outil $P_2$,

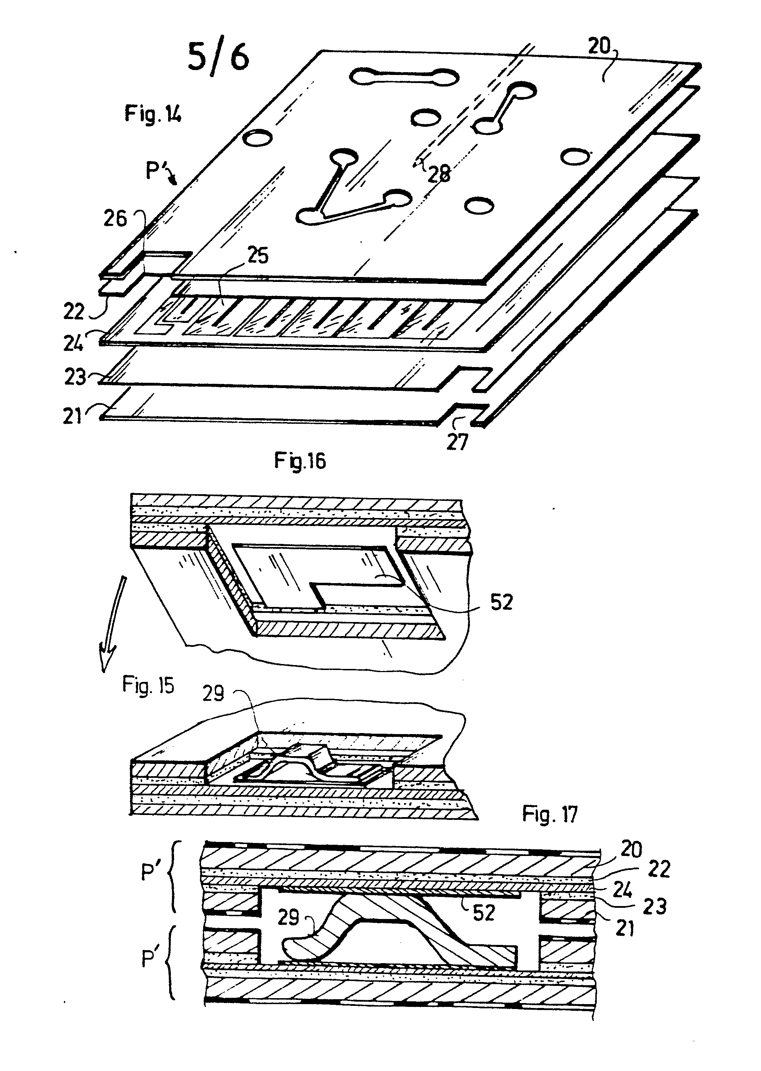

. les figures 14, 15, 16, 17 représentent respectivement en perspective d'ensemble, en perspectives de détail et en coupe de détail, un mode de réalisation de plaque-outil autochauffante P', permettant d'exécuter dans de meilleures conditions l'opération (c) sur plusieurs couches,

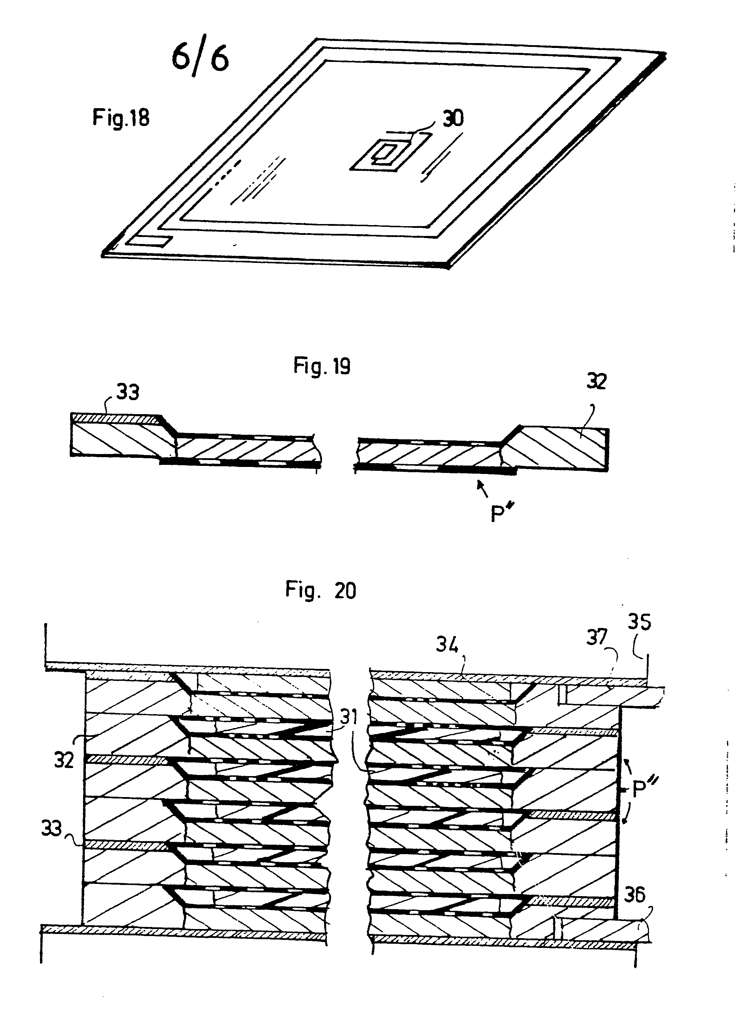

. la figure 18 représente en perspective partielle un autre mode de réalisation de plaque-outil autochauffante,

. la figure 19 représente en coupe schématique un autre mode de réalisation de plaque-outil auto-chauffante P", cependant que la figure 20 illustre l'utilisation de celle-ci.

Le procédé conforme à l'invention pour la fabrication d'une couche de circuit imprimé comprend essentiellement quatre phases :

(a) réalisation d'une plaque-outil réutilisable,

(b) garniture électrolytique de la plaque-outil au moyen d'un matériau conducteur, appelé à former les dépôts conducteurs de la couche,

(c) transfert des dépôts conducteurs vers le support isolant de la couche,

(d) séparation de la plaque-outil et du support isolant.

La phase (a) est réalisée une seule fois pour un grand nombre de couches pouvant aller de plusieurs dizaines à quelques centaines, alors que les phases (b), (c) et (d) sont exécutées de façon répétitive pour chaque couche, la plaque-outil étant reconstituée au terme de la phase (d) dans l'état où elle se trouve après sa fabrication au terme de (a).

Les phases (a), (b), (c), (d) peuvent revêtir plusieurs formes de mise en oeuvre dont des exemples sont décrits ci-après :

PHASE (a)

Un premier mode de mise en oeuvre de la phase (a) est illustré aux figures 1a à 1j.

Une plaque de base 1 en acier inoxydable est usinée à la dimension des couches à réaliser, avec une épaisseur de l'ordre de 0,5 à 1mm . (figure 1a). La surface de cette plaque est sablée, dégraissée et dépoussiérée de façon qu'elle soit parfaitement propre.

Cette plaque est ensuite soumise à une électrolyse afin d'y déposer, sur ses deux faces, un laminé de cuivre 2 dont l'épaisseur peut être de l'ordre de 5 à 100 microns (figure 1b).

La plaque obtenue est enduite sur ses deux faces d'un film photo—polymérisable 3 d'un type connu tel que film photo-polymérisable aux ultraviolets (figure 1c).

Pour chacune des faces de la plaque, un cliché 4 comportant des zones transparentes aux ultraviolets et des zones opaques est réalisé de façon classique, les zones transparentes étant disposées selon le schéma des dépôts conducteurs (D) des couches à réaliser ; ce cliché est placé sur le film polymérisable 3 et la plaque est soumise à un rayonnement ultraviolet à travers ledit cliché sur une machine d'insolation (figure 1d).

/et développement/

Après polymérisation/du film 3, les zones de la plaque correspondant aux zones conductrices (D) des couches à réaliser se trouvent recouvertes d'une couche de protection 3' constituée par le matériau du film polymérisé, les autres zones étant découvertes jusqu'à la surface de la couche de cuivre 2 (figure 1e).

La plaque est alors soumise à une opération de gravure qui attaque les parties de la couche de cuivre 2 non protégée et les élimine (figure 1f).

Les faces de la plaque sont ensuite enduites à chaud (400°C environ) au moyen d'une couche isolante de polytétrafluoroéthylène 5 (figure 1g).

Une rectification des faces de la plaque est réalisée jusqu'au niveau du film 3' qui devient apparent (figure 1h) ; ce film, désagrégé lors de l'enduction à chaud, est éliminé par un simple rinçage.

La plaque est soumise à une nouvelle opération de gravure qui élimine les parties restantes de la couche de cuivre 2 (figure 1j) et fournit la plaque-outil $P_1$ ; la phase (a) est terminée et la plaque-outil $P_1$ est prête pour autoriser la fabrication d'une série de couches comme on le verra plus loin.

Cette plaque-outil $P_1$ qui a été schématisée en perspective à la figure 2 est donc constituée d'une plaque de base métallique 1 aux faces lisses partiellement recouvertes d'un revêtement en relief 5' de polytétrafluoroéthylène, reproduisant de façon inverse (plein pour creux) le schéma des dépôts conducteurs de la couche à réaliser et préservant donc des zones en retrait 6 qui correspondent auxdits dépôts.

Les opérations ci-dessus évoquées sont chacune classiques en elles-mêmes et peuvent être effectuées sur les équipements courants dont sont dotés les ateliers de fabrication de circuits imprimés. Compte-tenu de leur faible fréquence par rapport au nombre de couches fabriquées (et donc de l'influence très faible de leur coût sur le coût de chaque couche), ces opérations peuvent être menées avec un grand soin par une main-d'oeuvre spécialisée afin d'obtenir une grande qualité de réalisation des plaques-outils.

En outre, au moins deux trous calibrés tels que 7 sont réalisés dans la plaque-outil $P_1$ de façon à traverser celle-ci en dehors des zones 6 (en particulier près des bords de cette plaque-outil) ; ces trous sont centrés sur des points parfaitement positionnés par rapport aux zones 6 et serviront à régler de façon rigoureuse la position relative des plaques-outils et supports isolants lors de la phase (c) de transfert.

Les figures 3a à 3f illustrent un autre mode de mise-en-oeuvre de la phase (a) de fabrication des plaques-outils.

Une plaque de base 8 semblable à la plaque 1 est usinée (figure 3a) et enduite d'une couche de protection 9 (figure 3b) recouvrant les zones correspondant aux parties conductrices de la couche à réaliser (cette enduction peut être réalisée par une opération similaire à celle déjà évoquée : polymérisation d'un film à travers un cliché sous insolation

11

aux ultraviolets).

Une opération de gravure est alors effectuée pour attaquer sur une certaine épaisseur les parties non protégées de la plaque de base 8 (figure 3c).

La plaque est ensuite soumise à une opération de dépelliculage qui élimine la couche de protection 9 (figure 3d).

Les faces de la plaque sont ensuite enduites à chaud au moyen d'une couche isolante 10 par exemple à base de silicone (figure 3e).

Une rectification des faces de la plaque est opérée pour mettre à nouveau à fleur l'acier inoxydable de la plaque dans les parties en relief de celle-ci, les autres parties demeurant couvertes par le revêtement silicone 10'.

La phase (a) est alors terminée et fournit une plaque-outil $P_2$ dont les faces sont dans ce cas planes ; les zones conductrices apparentes (8') de la plaque-outil $P_2$ (correspondant aux parties conductrices des couches à réaliser) sont formées par les parties de la plaque de base, situées en relief par rapport aux autres zones de celle-ci,(ces autres zones étant recouvertes du revêtement en silicone 10').

Comme on le verra plus loin, ce type de plaque-outil $P_2$ permet d'obtenir une meilleure adhérence des dépôts conducteurs sur le support isolant définitif au terme de la phase (c). De plus, et c'est là un avantage important, le revêtement 10' possède une excellente tenue sur la plaque de base 8, ce qui augmente le nombre de couches pouvant être fabriquées avec ladite plaque-outil.

Un autre mode de mise en oeuvre de la phase (a) permettant d'obtenir une plaque-outil identique à la plaque-outil $P_1$ est illustré aux figures 4a, 4b et 4c. Ce mode de mise-en-oeuvre consiste à recouvrir totalement les faces d'une plaque de base similaire aux précédentes, d'un revêtement 11 d'épaisseur constante, en silicone, polytétrafluoroéthylène ou fluocarbone, et à usiner ensuite ce revêtement pour en éliminer les parties correspondant aux zones conductrices de la couche à réaliser.

Cet usinage peut être mécanique (fraisage, perçage) ou être effectué par un faisceau laser focalisé sur la surface du revêtement à éliminer, la puissance de ce faisceau étant adaptée pour sublimer le matériau du revêtement sans altérer la surface de la plaque de base.

Les figures 5a et 5b illustrent la réalisation d'une plaque-outil, comparable à la plaque-outil $P_2$, c'est-à-dire sur laquelle les parties conductrices apparentes (50') sont situées en relief par rapport aux autres zones de la plaque de base (le revêtement 51 étant disposé sur ces autres zones).

Dans cet exemple de réalisation, les parties conductrices apparentes 50' sont formées par un placage métallique sélectif qui est déposé en surface de la plaque de base selon le schéma des dépôts conducteurs (D) de la couche à réaliser ; ce placage peut être réalisé en chrome, nickel, cuivre, aluminium et leurs alliages.

Le procédé de mise-en-oeuvre consiste/à en particulier recouvrir sélectivement une plaque de base en acier inoxydable au moyen d'un revêtement du type silicone, polytétrafluoroéthylène ou fluocarbone (figure 5a) selon un processus similaire à celui représenté aux figures 1a à 1j ou 4a à 4c. Le placage est ensuite réalisé électrolytiquement pour fournir une plaque-outil possédant sensiblement les avantages de la plaque-outil $P_2$ (figure 5b).

PHASE (b)

La phase (b) consiste à réaliser une opération de métallisation électrolytique pour recouvrir les parties conductrices de la plaque-outil d'une épaisseur de métal, par exemple de cuivre, appelé à former le matériau des pistes conductrices des couches.

La figure 6 illustre cette opération (b) pour une plaque-outil $P_1$ ; l'épaisseur de cuivre électrolytique 12 remplit les zones 6 laissées en retrait par le revêtement isolant.

La figure 7 illustre cette opération (b) pour une plaque-outil $P_2$ ; l'épaisseur de cuivre 13 se dépose en relief sur les zones conductrices 8' de la plaque-outil.

L'une ou l'autre de ces opérations peut

13

s'effectuer sur une chaîne de métallisation électrolytique traditionnelle et est de mise-en-oeuvre simple, peu onéreuse, ne consommant aucun matériau élaboré et exécutable par une main-d'oeuvre dépourvue de qualification particulière.

Les bains utilisés pour réaliser ce dépôt électrolytique sont bien connus en soi par l'homme de l'art et peuvent présenter une composition chimique permettant une réduction et une homogénéïsation de la force d'adhérence du métal déposé sur les parties conductrices de la plaque-outil.

Au terme d'un séchage réalisé sur ladite chaîne, la phase (b) est terminée et la plaque-outil est prête pour la phase (c) suivante.

PHASE (c)

Cette phase consiste à transférer et fixer sur des supports isolants définitifs les épaisseurs de cuivre 12 ou 13, déposées sur les plaques-outils $P_1$ ou $P_2$ lors de la phase précédente (b).

Cette phase est illustrée aux figures 8 et 9 respectivement dans le cas d'une plaque-outil $P_1$ et dans le cas d'une plaque-outil $P_2$.

Le support isolant de chaque couche à réaliser est constitué par une feuille en résine époxyde, telle que 14 ou 15, qui est appliquée et pressée à l'état non polymérisé contre la plaque-outil $P_1$ ou $P_2$. L'ensemble est chauffé de façon appropriée pour engendrer la polymérisation de la résine.

Dans le cas de la plaque-outil $P_1$ (figure 8), l'épaisseur de cuivre 12 adhère par une face, en surface de la feuille d'époxyde 14.

Dans le cas de la plaque-outil $P_2$ (figure 9), l'épaisseur de cuivre 13 pénètre dans la feuille d'époxyde 15 grâce au fluage de la résine pendant la polymérisation et adhère à celle-ci par une face et pas ses chants latéraux.

Cette phase (c) est avantageusement réalisée simultanément en empilant en alternance des plaques-outils $P_1$ ou $P_2$ et des feuilles de résine 14 ou 15 de façon à obtenir simultanément plusieurs couches de circuits imprimés, comme le représente la figure 10.

Des goupilles telles que 16 sont introduites dans les trous 7 des plaques-outils et dans les trous similaires 17 pratiqués dans les feuilles de résine.

De préférence, comme l'illustre la figure 11, des rondelles 18 sont enfilées autour des goupilles 16 au niveau de chaque feuille de résine. Ces rondelles 18, métalliques ou prédécoupées en matériau isolant (résines époxydes polymérisées...), présentent une épaisseur calibrée sensiblement égale à l'épaisseur des feuilles de résine et une âme de diamètre calibré correspondant à celui des goupilles 16 ; elles sont moyées dans les feuilles de résine lors de la polymérisation et servent de barrières aux coulées de résine pendant le fluage ; lorsque la couche de circuit imprimé est terminée, elles délimitent dans celle-ci des trous très précisément calibrés et positionnés, sans bavure, qui amélioreront la qualité du positionnement des couches lors de leur assemblage en vue de la réalisation d'un circuit imprimé multi-couche.

L'empilage précité peut être disposé dans une presse à plateaux chauffants de type classique 19, adaptée pour exercer la pression appropriée (de l'ordre de 10 à 30 bars) et assurer le dégagement calorifique nécessaire à la polymérisation (température de l'ordre de 150° à 200 °C).

Toutefois, comme on le verra plus loin, il est avantageux de prévoir des plaques-outils autochauffantes aptes à apporter, de façon plus uniforme au coeur de l'empilage, l'énergie calorifique nécessaire ; dans ce cas, la presse a pour seule fonction d'exercer la pression appropriée sur l'empilage.

PHASE (d)

Lorsque la polymérisation de la résine époxyde est terminée, le démontage des couches peut être effectué en libérant les plateaux de presse.

Cette opération est schématisée à la figure 12 dans le cas d'une plaque-outil $P_1$ et à la figure 13 dans la cas d'une plaque-outil $P_2$.

Dans les deux cas, le démoulage se produit aisément sans arrachement ou collage intempestif. En effet, le cuivre des épaisseurs 12 ou 13 qui adhère préférentiellement et fortement sur la résine époxyde, se détache aisément de la surface conductrice de la plaque de base 1, cependant que le

15

revêtement en polytétrafluoroéthylène ou en silicone 5' ou 10' adhère préférentiellement sur l'acier inoxydable et, au contraire, joue le rôle de démoulant à l'égard de la résine avec c laquelle son coefficient d'adhérence est très faible.

On obtient de la sorte :

. d'une part, une couche de circuit imprimé constituée par un support isolant S formé d'une feuille de résine époxyde polymérisée, sur lequel sont fortement collés des dépôts conducteurs D formés par les épaisseurs de cuivre 12 ou 13, dépôts qui sont positionnés selon le schéma des liaisons électriques à établir dans le circuit imprimé,

. d'autre part, la plaque-outil $P_1$ ou $P_2$, reconstituée et prête pour un nouveau cycle (b), (c), (d).

La couche de circuit imprimé (S, D) est prête à être assemblée de façon classique avec d'autres couches, puis percée en vue de former un circuit multi-couches.

Après avoir illustré les diverses phases (a), (b), (c), (d) du procédé conforme à l'invention, sont décrits ci-après en référence aux figures 14 à 20, des modes de réalisation perfectionnés de plaques-outils.

Dans le cas où un nombre notable de couches sont pressées et polymérisées simultanément lors de la phase (c), un chauffage par plateaux chauffants de presse privilégie fortement les couches placées aux extrémités de l'empilage ; il en résulte que, pour faire subir aux couches centrales le cycle thermique strictement nécessaire à la polymérisation, il est nécessaire de rallonger le cycle total en raison de l'effet d'écran thermique induit par les couches extérieures. De plus, on rompt l'homogénéité du traitement thermo-mécanique entre les diverses couches, ce qui limite le nombre de couches qu'il est possible de presser simultanément.

Un des objectifs de l'invention est de pallier ce défaut en fournissant des plaques-outils autochauffantes, capables d'apporter l'énergie calorifique in situ de façon sensiblement homogène pour toutes les couches. Il est ainsi possible d'augmenter le nombre de couches simultanément pressées et de soumettre celles-ci au cycle thermique optimum.

Les figures 14, 15, 16 et 17 présentent un premier mode de réalisation de plaque-outil auto-chauffante P'. Celle-ci comprend deux plaques externes d'acier inoxydable 20 et 21 dotées en surface des revêtements isolants, obtenus à l'issue de la phase (a), deux feuilles internes 22 et 23 d'un matériau isolant sur le plan électrique et, entre celles-ci, un support isolant 24 porteur d'un circuit résistant continu 25 qui peut être fixé sur l'une de ses faces ou sur les deux (en l'exemple sur les deux faces). Les matériaux isolants sont choisis pour être compatibles avec les températures de chauffage (polyimide par exemple).

Une échancrure telle que 26 ou 27 est ménagée en bordure des plaque 20 et feuille 22 ou plaque 21 et feuille 23 en vue d'autoriser les liaisons électriques du circuit 25 avec les circuits correspondants des deux plaques-outils voisines.

Les échancrures ménagées dans les feuilles isolantes 22 et 23 sont moins profondes que celles ménagées dans les plaques d'acier 20 et 21 de façon à laisser l'isolant déborder légèrement par rapport aux plaques 20 et 21.

L'ensemble des éléments ci-dessus décrits est collé sous pression pour former une plaque-outil composite auto-chauffante.

La valeur locale de la résistance du circuit 25 est prévue de façon à engendrer un dégagement calorique plus important sur les bords qu'au centre de la plaque-outil et à compenser le gradient de température qui a tendance à s'établir naturellement du fait de la géométrie de l'élément. Cet effet permettant d'obtenir une bonne homogénéité de température peut par exemple être obtenu en faisant décroître la largeur des pistes résistives du centre de l'outillage vers sa périphérie.

Une sonde 28 (soudure bi-métallique ou autre) est avantageusement insérée dans la plaque-outil pour piloter un ensemble de régulation de l'alimentation électrique.

Les connexions électriques entre les plaques - outils (ou entre chaque plaque outil extrême et l'alimentation électrique) peuvent être réalisées comme l'illustrent les figures de détail 15, 16 et 17, à travers les échancrures 26 et 27.

Une lame conductrice 29, en particulier en alliage de bronze, est soudée à une extrémité du circuit résistif de chaque plaque-outil, cette lame conductrice étant appelée à venir en appui avec l'autre extrémité (52) du circuit résistif d'une autre plaque-outil (cette dernière extrémité 52 pouvant être équipée d'une plaquette en cuivre, nickel, chrome... pour limiter l'usure au niveau de la connexion).

La figure 17 montre deux plaques-outils P' électriquement reliées ; l'espace entre ces deux plaques correspond à la feuille de résine (non représentée) laquelle s'étend jusqu'en bordure des échancrures 26, 27 ou peut, le cas échéant s'étendre jusqu'en bordure des plaques et être elle-même dotée d'échancrures similaires.

La figure 18 illustre partiellement un autre mode de réalisation de plaque-outil auto-chauffante.

Dans ce mode de réalisation, les plaques 20 et 21 sont en matériau ferromagnétique (acier inoxydable ferromagnétique) et le circuit résistif 25 est remplacé par un circuit électrique 30, conçu en forme de spirale pour créer un nombre d'ampère-tours approprié pour induire un champ magnétique lorsqu'il est traversé par un courant électrique alternatif de fréquence déterminée.

Par exemple, le circuit résistif 25 peut être constitué d'une spirale conductrice, disposée sur une face du support isolant interne et reliée par son centre à travers une fenêtre de traversée, à une autre spirale disposée sur l'autre face (le sens des deux spirales étant tels que le nombre d'ampères-tours s'ajoute).

Le dégagement calorifique produit par l'effet résistif est ainsi complété par les effets exothermiques créés par les courants de Foulcault et les phénomènes d'hystérésis induits par les variations du champ magnétique au coeur du matériau ferromagnétique des plaques externes.

Un autre mode de réalisation de plaque-outil P" est représenté en coupe à la figure 19, la figure 20 montrant l'empilage de plusieurs de ces plaques-outils et de feuilles de résine telles que 31 au cours de l'opération (c).

18

Chaque plaque-outil P" comprend (comme les plaques-outils P$_1$ et P$_2$) une plaque de base, en àcier inoxydable ferromagnétique dotée du revêtement isolant reproduisant en négatif le schéma des pistes conductrices des couches à réalisér. En bordure, des barrettes de cuivre, d'épaisseur calibrée, telles que 32, sont brasées sur chaque plaque de base afin d'assurer les connexions électriques entre plaques-outils. L'épaisseur de ces barrettes est prévue comme l'illustrent la figure 20 de façon à préserver entre paires de plaques-outils l'espace nécessaire à une couche.

De plus, des barrettes isolantes, d'épaisseur calibrée, telles que 33, sont fixées sur une barrette de cuivre sur deux, de façon que les plaques de base des plaques-outils forment un ensemble de résistances montées en série.

Des plaques d'isolant telles que 34 recouvrent les plateaux de presse 35 et des barrettes de cuivre 36 et 37 assurent l'alimentation électrique au niveau des plateaux de presse.

Bien entendu, l'invention n'est pas limitée aux termes de la description précédente mais en comprend toutes les variantes.

19

## REVENDICATIONS

1/ - Procédé de fabrication d'une couche de circuit imprimé, comprenant au moins un support électriquement isolant (S) doté sur au moins une face, de dépôts en un matériau électriquement conducteur (D) adhérant sur ledit support, lesdits dépôts (D) étant disposés selon un schéma électrique correspondant aux liaisons électriques à établir dans le circuit imprimé, ledit procédé de fabrication étant caractérisé en ce qu'il consiste :

- (a) à réaliser au moins un outillage réutilisable, dit plaque-outil ($P_1$, $P_2$, P', P"), comprenant une plaque de base (1, 8) constituée, au moins en surface, d'un matériau électriquement conducteur et partiellement recouverte d'un revêtement électriquement isolant (5', 10') adhérant sur ladite plaque et reproduisant le schéma inverse des dépôts conducteurs de la couche à réaliser, le matériau conducteur de la plaque de base (1, 8) et le matériau du revêtement isolant (5', 10') étant choisis en fonction des matériaux appelés à constituer le support isolant (S) et les dépôts conducteurs (D) de la couche à réaliser, de sorte que :

. la force d'adhérence du revêtement isolant (5', 10') par rapport à la plaque de base (1, 8) soit supérieure à la force d'adhérence dudit revêtement (5', 10') par rapport au support isolant (S) de la couche à réaliser,

. et que la force d'adhérence de la plaque de base (1, 8) par rapport aux dépôts conducteurs (D) soit inférieure à la force d'adhérence desdits dépôts (D) par rapport au support isolants (S).

- (b) à déposer sélectivement sur les parties conductrices de la plaque-outil ($P_1$, $P_2$, P', P"), non recouvertes du revêtement isolant (5', 10'), une épaisseur du matériau conducteur appelé à former les dépôts conducteurs (D) de la couche à réaliser,

- (c) à appliquer et presser la plaque-outil ainsi obtenue sur un support isolant (S) afin de transférer et coller l'épaisseur du matériau conducteur sur ledit support,

- (d) à séparer la plaque-outil et le support isolant afin d'obtenir la couche de circuit imprimé et de reconstituer la plaque-outil ($P_1$, $P_2$, P', P") telle que réalisée en (a).

2/ - Procédé selon la revendication 1 pour la fabrication d'une couche constituée par un support (S) de résine polymérisée, notamment époxyde, doté sur au moins une face de dépôts métalliques (D), notamment de cuivre, ledit procédé étant caractérisé en ce que la plaque-outil ($P_1$, $P_2$, P', P") est réalisée à l'opération ($\alpha$) en choisissant une plaque de base (1, 8) constituée, au moins en surface, d'un métal du groupe : acier inoxydable, nickel, chrome, aluminium, cuivre et leur alliages, , et en choisissant un revêtement (5', 10') en un matériau du groupe : polytétrafluoroéthylènes, silicones, fluorocarbones.

3/ - Procédé selon l'une des revendications 1 ou 2, caractérisé en ce que l'opération (a) de réalisation de la plaque-outil ($P_2$) consiste à graver la plaque de base (8) de façon à faire apparaître en relief les zones destinées à demeurer apparentes, et à recouvrir les autres zones de la plaque de base au moyen du revêtement (10').

4/ - Procédé selon l'une des revendications 1 ou 2, caractérisé en ce que l'opération (a) de réalisation de la plaque-outil consiste à effectuer un placage métallique sélectif (50') en surface de la plaque de base selon le schéma des dépôts conducteurs (D) de la couche à réaliser, et à recouvrir les autres zones de la plaque de base au moyen du revêtement, le métal du placage sélectif étant choisi dans le groupe : chrome, nickel, cuivre et leurs alliages.

5/ - Procédé selon l'une des revendications 1 ou 2, caractérisé en ce que l'opération (a) de réalisation de la plaque-outil ($P_1$) consiste à effectuer une enduction au moyen du matériau isolant du revêtement (5') de façon à conserver sélectivement en relief sur la plaque de base (1) ledit

0056668

21

revêtement (5') selon le schéma inverse des dépôts conducteurs (D) de la couche à réaliser.

6/ - Procédé selon l'une des revendications 1, 2, 3, 4 ou 5, dans lequel l'opération (b) consiste à effectuer un dépôt électrolytique de matériau conducteur/(12,13) sur les parties conductrices apparentes de la plaque-outil ($P_1$, $P_2$, P', P").

7/ - Procédé selon l'une des revendications précédentes pour la fabrication de couches ayant un support (S) constitué par au moins une résine polymérisée, dans lequel l'opération (c) est réalisée pour obtenir simultanément plusieurs couches de circuit imprimé et consiste à réaliser un empilage comprenant des plaques-outils ($P_1$, $P_2$, P', P") entre lesquelles sont interposées des feuilles de résines non polymérisées (14, 15, 31), à appliquer une pression sur ledit empilage et à porter celui-ci à une température adaptée pour engendrer la polymérisation de la résine.

8/ - Procédé selon la revendication 7, caractérisé en ce que chaque plaque-outil (P', P") est réalisée avec un circuit électrique intégré (25, 30) doté de connexions d'alimentation (29, 32), les circuits des plaques outils de l'empilage étant alimentés par un courant électrique approprié pour engendrer, par effet résistif et/ou inductif, un dégagement calorifique apte à assurer la polymérisation de la résine.

9/ - Procédé de fabrication selon l'une des revendications 7 ou 8, dans lequel chaque plaque-outil ($P_1$, $P_2$, P', P") est réalisée avec au moins deux trous calibrés de positionnement (7) la traversant, les feuilles de résine (14) de l'empilage étant dotées de trous identiques (17), des goupilles de positionnement (16) étant introduites dans les trous superposés de l'empilage lors de la réalisation de celui-ci.

10/ - Procédé selon la revendication 9, caractérisé en ce que des rondelles (18) sont enfilées autour des goupilles (16) au moment de la mise en place de chaque feuille de résine (14) en vue d'être noyées autour des trous de celles-ci lors de la polymérisation.

11/ - Procédé selon l'une des revendications précédentes, pour la fabrication d'une série de couches identiques de circuits imprimés, consistant à réaliser une plaque-outil ($P_1$, $P_2$, P', P") conformément à l'opération (a) et à réaliser ensuite de façon répétitive pour chaque couche de la série, les opérations (b), (c) et (d) avec ladite plaque-outil.

12/ - Plaque-outil pour la fabrication de couches de circuit imprimé, en vue de la mise-en-oeuvre du procédé conforme à l'une des revendications précédentes, caractérisée en ce qu'elle comprend une plaque de base (1, 8) constituée, au moins en surface, d'un métal du groupe : acier inoxydable, nickel, chrome, aluminium cuivre et leurs alliages , et un revêtement (5', 10') disposé sur au moins une face de ladite plaque de base et constitué en un matériau isolant du groupe : polytétrafluoroéthylènes, silicones, fluocarbones, ledit revêtement étant positionné sur la plaque de base de façon à laisser apparentes des parties conductrices de celle-ci selon un schéma prédéterminé.

13/ - Plaque-outil selon la revendication 12, caractérisée en ce que les parties conductrices apparentes de la plaque de base (8) sont situées en relief par rapport aux autres zones de cette plaque, le revêtement (10') étant disposé sur ces autres zones.

14/ - Plaque-outil selon la revendication 12, caractérisée en ce que les faces de la plaque de base (1) sont lisses, le revêtement (5') étant disposé en relief sur celles-ci.

15/ - Plaque-outil selon l'une des revendications 12, 13 ou 14, caractérisée en ce que la plaque de base comprend un circuit électrique doté de connexions d'alimentation, apte à engendrer un dégagement calorifique.

16/ - Plaque-outil selon la revendication 15, caractérisée en ce que la plaque de base est constituée par une plaque composite comprenant deux plaques externes (20, 21) portant en surface le revêtement (5', 10'), des feuilles internes isolantes (22, 23) et, entre celles-ci, un circuit résistif et/ou inductif (25, 30) pourvu de connexions d'alimentation électrique (29).

1/6

Fig. 1a

Fig. 1b

Fig. 1c

Fig. 1d

Fig. 1e

Fig.1f

Fig. 1g

Fig. 1h

Fig. 1j

Fig.2

Fig. 3a

Fig. 3b

Fig. 3c

Fig. 3d

Fig. 3e

Fig. 3f

Fig. 4a

Fig. 4b

Fig. 4c

Fig. 5a

Fig. 5b

Fig. 6

12  5'

$P_1$

Fig. 7

13  8'

$P_2$

Fig. 8

14  12

$P_1$

Fig. 9

13  15

$P_2$

Fig. 10

14

P₁

16

19

Fig. 11

18

16

17

14

7

Fig. 12

S

5′

1

D

P₁

Fig. 13

S

5

D

10′

P₂

5/6

Fig. 14

P'

26

22

24

23

21

25

20

28

27

Fig. 16

52

Fig. 15

29

Fig. 17

P' {

20

22

24

23

21

29

52

6/6

Fig.18

30

Fig. 19

33
32

P"

Fig. 20

34
37
35

31

32

33

P"

36

**Office européen des brevets**

## RAPPORT DE RECHERCHE EUROPEENNE

EP 82 20 0024

| | DOCUMENTS CONSIDERES COMME PERTINENTS | | CLASSEMENT DE LA DEMANDE (Int. Cl. ³) |
|---|---|---|---|
| Catégorie | Citation du document avec indication, en cas de besoin, des parties pertinentes | Revendication concernée | |
| X | US - A - 2 984 595 (K.SHUMPELT et al.)<br>  * Colonne 1, lignes 44-49; exemples * | 1 | H 05 K 3/20 |
| X | FR - A - 1 549 850 (IBM)<br>  * Page 2, colonne 1, dernier alinéa - page 3, colonne 2, alinéa 2; page 3, colonne 2, dernier alinéa * | 1-3,6, 11,13 | |
| | | | **DOMAINES TECHNIQUES RECHERCHES (Int. Cl. ³)** |
| X | FR - A - 1 179 653 (J.M.N. HANLET)<br>  * Page 2, colonne 1, alinéa 2 - page 3, colonne 2, alinéa 2 * | 1,5,6, 14 | H 05 K 3/20<br>B 29 D 3/00 |
| X | US - A - 3 582 476 (B.C. KNISLEY)<br>  * Colonne 2, ligne 26 - colonne 3, ligne 29 * | 1,4,6, 13 | |
| A | FR - A - 1 433 088 (IBM)<br>  * Page 3, colonne 2, alinéa 2 - page 4, colonne 1, alinéa 2 * | 7,9 | **CATEGORIE DES DOCUMENTS CITES** |
| A | GB - A - 1 321 305 (CUPRO SAPPHIRE LTD)<br>  * Page 1, ligne 66 - page 2, ligne 79 * | 8,15 | X: particulièrement pertinent à lui seul<br>Y: particulièrement pertinent en combinaison avec un autre document de la même catégorie<br>A: arrière-plan technologique<br>O: divulgation non-écrite<br>P: document intercalaire<br>T: théorie ou principe à la base de l'invention<br>E: document de brevet antérieur, mais publié à la date de dépôt ou après cette date<br>D: cité dans la demande<br>L: cité pour d'autres raisons |
| X | Le présent rapport de recherche a été établi pour toutes les revendications | | &: membre de la même famille, document correspondant |

| Lieu de la recherche | Date d'achevement de la recherche | Examinateur |
|---|---|---|
| La Haye | 20-04-1982 | SCHUERMANS |

OEB Form 1503.1   06.78